# EUROPÄISCHE PATENTSCHRIFT

(11) **EP 2 862 186 B1**
(45) Veröffentlichungstag und Bekanntmachung des Hinweises auf die Patenterteilung: **06.07.2016**
(21) Anmeldenummer: 13725664.0
(22) Anmeldetag: 28.05.2013
(51) Int. Cl.: H01G 4/232, H01L 41/273, H01L 41/293

(54) **VERFAHREN ZUR HERSTELLUNG EINES KERAMISCHEN BAUELEMENTS**
METHOD FOR PRODUCING A CERAMIC COMPONENT
PROCÉDÉ DE FABRICATION D'UN ÉLÉMENT CÉRAMIQUE

(30) Priorität: 19.06.2012 DE 102012105318
(43) Veröffentlichungstag der Anmeldung: 22.04.2015
(73) Patentinhaber: Epcos AG, 81669 München (DE)
(72) Erfinder: RINNER, Franz, A-8530 Deutschlandsberg (AT); AUER, Christoph, A-8043 Graz (AT); HOFFMANN, Christian, 81825 München (DE)
(74) Vertreter: Epping - Hermann - Fischer
(86) Internationale Anmeldenummer: PCT/EP2013/060975
(87) Internationale Veröffentlichungsnummer: WO 2013/189701

(56) Entgegenhaltungen:
- EP-A2- 0 167 392
- US-A- 5 173 162

## Beschreibung

Die Erfindung betrifft ein Verfahren zur Herstellung eines keramischen Bauelements sowie ein keramisches Bauelement. Das Bauelement kann beispielsweise Bestandteil eines Piezo-Aktuators sein. Beispielsweise kann das Bauelement in Vielschicht-Technologie hergestellt sein. Solche Piezo-Aktuatoren in Vielschicht-Technologie können zum Beispiel in Kraftstoff-Einspritzsystemen von Kraftfahrzeugen eingesetzt werden.

Aus der Druckschrift DE 102006003070 B3 geht ein Verfahren zur Herstellung eines als Stapel ausgebildeten elektronischen Bauelements mit einer Mehrzahl von Elektrodenschichten und keramischen Schichten hervor, bei dem ein Isoliermaterial mittels eines Lasers strukturiert wird. Aus der Druckschrift DE 102007058873 A1 geht ein Piezoaktor mit einer Isolationsschicht hervor, bei dem die Isolationsschicht als vorstrukturierte Folie auflaminiert wird oder eine auflaminierte, fotoempfindliche Isolationsfolie nachträglich fotostrukturiert wird. Druckschrift US 5,597,494 schlägt ein elektronisches Vielschichtbauelement vor, bei dem die oberflächennahen Bereiche von Innenelektroden elektrochemisch zurückgeätzt werden und die entstandenen Aussparungen mit einem Isoliermaterial aufgefüllt werden. Diese Verfahren umfassen eine Vielzahl von separaten Bearbeitungsschritten und sind sowohl technisch als auch apparativ kompliziert und aufwendig zu realisieren. Die Druckschrift EP 0167392 A2 beschreibt ein Verfahren zur elektrophoretischen Abscheidung von Isolationsmaterial auf den freiliegenden Kanten der Innenelektroden, wobei jeweils ein Satz der Innenelektroden gegen die Badelektrode mit einer Spannung belegt wird.

Es ist daher eine zu lösende Aufgabe der Erfindung, ein verbessertes Verfahren zur Herstellung eines keramischen Bauelements und ein verbessertes keramisches Bauelement anzugeben.

Es wird ein Verfahren zur Herstellung eines keramischen Bauelements angegeben. Das Verfahren umfasst in einem Verfahrensschritt a) das Bereitstellen eines Grundkörpers mit internen Elektroden, deren Außenkanten sich auf zumindest einer ersten Außenoberfläche des Grundkörpers befinden. Im folgenden Verfahrensschritt b) wird die erste Außenoberfläche des Grundkörpers mit einer Zusammensetzung kontaktiert, welche ein elektrophoretisch mobiles Isoliermaterial umfasst. Das Isoliermaterial wird daraufhin elektrophoretisch auf den Außenkanten der internen Elektroden auf der ersten Außenoberfläche des Grundkörpers abgeschieden. In einem weiteren Verfahrensschritt c) wird aus dem Isoliermaterial auf den Außenkanten der internen Elektroden eine isolierende Schicht erzeugt.

Ein wesentlicher Vorteil des erfindungsgemäßen Verfahrens besteht darin, dass durch die elektrophoretische Abscheidung gleichzeitig eine Strukturierung des Isoliermaterials auf den Außenkanten der internen Elektroden erreicht wird. Insbesondere kann dadurch auf weitere strukturierende Maßnahmen wie eine Vorstrukturierung der Außenkanten der internen Elektroden und/oder der Außenoberfläche, wie es im Stand der Technik beispielsweise durch lithografische Verfahren oder Abtragungsverfahren üblich ist, verzichtet werden. Da die strukturierte Abscheidung mittels Elektrophorese im Wesentlichen auf den Bereich der Außenkanten der internen Elektroden begrenzt ist, kann zum Beispiel auch eine Nachstrukturierung der isolierenden Schicht, wie sie bei herkömmlichen Verfahren beispielsweise durch das gezielte Abtragen von Isoliermaterial erforderlich ist, entfallen. Insbesondere kann das erfindungsgemäße Verfahren aus diesen Gründen wirtschaftliche Vorteile haben, da aufwendige Prozessschritte wie Vor- und/oder Nachstrukturierung der isolierenden Schicht entfallen können.

Der Grundkörper kann beispielsweise ein monolithischer Keramikkörper sein, in den interne Elektroden eingebracht sind. Der Grundkörper kann auch keramische Schichten aufweisen. Die internen Elektroden können als interne Elektrodenschichten ausgebildet sein. Beispielsweise kann der Grundkörper einen Stapel aus keramischen Schichten und internen Elektrodenschichten aufweisen. Der Grundkörper kann zum Beispiel in Vielschicht-Technologie gefertigt sein, so dass keramische Schichten und interne Elektrodenschichten im Stapel alternieren, indem sich zwischen jeweils zwei internen Elektrodenschichten zumindest eine keramische Schicht befindet. In bestimmten Ausführungsformen können sich auch mehrere keramische Schichten zwischen zwei internen Elektrodenschichten befinden.

Der Grundkörper kann beispielsweise als monolithischer Körper in Vielschicht-Technologie gefertigt sein, indem keramische Grünfolien und interne Elektrodenschichten gemeinsam gesintert werden. Vorzugsweise wird der Grundkörper des keramischen Bauelements und des Verfahrens zu dessen Herstellung durch einen solchen monolithischen Sinterkörper bereitgestellt.

Die elektrophoretische Abscheidung beruht auf dem Prinzip, dass ein elektrophoretisch mobiles Isoliermaterial gemäß seiner elektrischen Ladung in einem elektrischen Feld entlang einer Spannungsdifferenz strukturiert auf den Außenkanten aufgrund unterschiedlicher elektrischer Potentiale dieser Außenkanten angeordnet wird. Ein elektrophoretisch mobiles Isoliermaterial umfasst erfindungsgemäß Isoliermaterial mit einer elektrischen Nettoladung. Beispielsweise kann das Isoliermaterial eine positive Nettoladung aufweisen. Alternativ kann das Isoliermaterial auch eine negative Nettoladung aufweisen. Beispielsweise kann es sich bei der Nettoladung um eine Stoffeigenschaft des Isoliermaterials handeln. Die Nettoladung kann aber auch durch äußere Faktoren erzeugt werden. Beispielsweise kann ein elektrisch geladenes oder ungeladenes Isoliermaterial auch mit einem weiteren elektrisch geladenen Material unter Bildung eines elektrophoretisch mobilen Isoliermaterials verbunden werden. Elektrophoretisch mobiles Isoliermaterial mit positiver Nettoladung wandert im elektrischen Feld in Richtung der positiven Spannung, d.h. zur Kathode, während elektrophoretisch mobiles Isoliermaterial mit negativer Nettoladung sich in Richtung der negativen Spannung, d.h. zur Anode, bewegt.

Unter den Außenkanten der internen Elektroden werden insbesondere diejenigen randseitigen Bereiche interner Elektroden verstanden, welche auf einer Außenoberfläche des Grundkörpers insbesondere in der gleichen Ebene wie die Außenoberfläche vorliegen. Beispielsweise kann es sich um eine oder mehrere der umlaufenden, flachen Außenseiten einer als Elektrodensschicht vorliegenden internen Elektrode handeln. Die isolierende Schicht ist vorzugsweise eine Schicht mit elektrisch isolierenden Eigenschaften, welche eine oder mehrere Außenkanten einer oder mehrerer interner Elektroden elektrisch isolierend abdecken kann.

Die internen Elektroden im Grundkörper umfassen zumindest eine erste interne Elektrode mit ersten Außenkanten und zumindest eine zweite interne Elektrode mit zweiten Außenkanten, wobei sich die ersten Außenkanten und die zweiten Außenkanten auf zumindest der ersten Außenoberfläche des Grundkörpers befinden. Im Verfahrensschritt b) wird das Isoliermaterial im Wesentlichen nur auf den ersten Außenkanten und nicht auf den zweiten Außenkanten auf der ersten Außenoberfläche abgeschieden, so dass die ersten Außenkanten durch die isolierende Schicht auf der ersten Außenoberfläche isoliert vorliegen und die zweiten Außenkanten zumindest teilweise frei liegen. Dadurch wird beispielsweise in einem späteren Verfahrensschritt eine selektive elektrische Kontaktierung der zweiten Außenkanten auf der ersten Außenoberfläche ermöglicht. Eine solche selektive elektrische Kontaktierung kann beispielsweise dazu dienen, die zumindest eine zweite interne Elektrode selektiv mit einem elektrischen Potenzial zu beaufschlagen.

In weiteren bevorzugten Ausführungsformen befinden sich die ersten und zweiten Außenkanten der ersten und zweiten internen Elektroden zusätzlich auf zumindest einer weiteren zweiten Außenoberfläche des Grundkörpers, insbesondere in der gleichen Ebene wie die zweite Außenoberfläche. In dieser Ausführungsform sieht das erfindungsgemäße Verfahren vor, die zweite Außenoberfläche in einem Verfahrensschritt b') nach b) mit einer Zusammensetzung zu kontaktieren, wobei das Isoliermaterial auf der zweiten Außenoberfläche im Wesentlichen nur auf den zweiten Außenkanten und nicht auf den ersten Außenkanten abgeschieden wird. Auf diese Weise wird beispielsweise in einem späteren Verfahrensschritt eine selektive elektrische Kontaktierung der zumindest teilweise freiliegenden ersten Außenkanten auf der zweiten Außenoberfläche ermöglicht, während hier die zweiten Außenkanten durch die isolierende Schicht auf der zweiten Außenoberfläche elektrisch isoliert vorliegen. Gemäß dieser bevorzugten Ausführungsform können somit beispielsweise die zumindest eine erste und zweite interne Elektrode selektiv mit unterschiedlichen elektrischen Potenzialen beaufschlagt werden. Üblicherweise ist die zweite Außenoberfläche eine weitere, von der ersten Außenoberfläche verschiedene Außenfläche des Grundkörpers. Beispielsweise handelt es sich bei der zweiten Außenoberfläche um die der ersten Außenoberfläche gegenüberliegende Fläche des Grundkörpers. Alternativ können die erste und die zweite Außenoberfläche auch benachbarte Flächen des Grundkörpers sein. In bestimmten Ausführungsformen können die erste und die zweite Außenoberfläche auch getrennte Bereiche derselben Fläche des Grundkörpers sein.

Vorzugsweise umfassen die internen Elektroden des Grundkörpers eine Mehrzahl erster interner Elektroden und eine Mehrzahl zweiter interner Elektroden. Beispielhaft sind solche Ausführungsformen, bei denen erste und zweite interne Elektroden im Grundkörper alternieren. Beispielsweise liegen im Grundkörper eine Vielzahl von ersten internen Elektroden und zweiten internen Elektroden von alternierender Folge vor, wobei jeweils zwischen einer ersten internen Elektrode und einer zweiten internen Elektrode zumindest eine keramische Schicht angeordnet ist. Dementsprechend wird beispielsweise im Verfahrenschritt b) das Isoliermaterial im Wesentlichen nur auf den ersten Außenkanten und nicht auf den zweiten Außenkanten abgeschieden, so dass auf der ersten Außenoberfläche zumindest teilweise freiliegende zweite Außenkanten und erste Außenkanten mit isolierender Schicht ebenfalls alternieren. Entsprechend wird gegebenenfalls in einem Verfahrensschritt b') das Isoliermaterial im Wesentlichen nur auf den zweiten Außenkanten und nicht auf den ersten Außenkanten abgeschieden, so dass auf der zweiten Außenoberfläche zumindest teilweise freiliegende erste Außenkanten und zweite Außenkanten mit isolierender Schicht alternieren. Alternativ zur alternierenden Folge können im Grundkörper auch Gruppen erster interner Elektroden und Gruppen zweiter interner Elektroden vorliegen. Erfindungsgemäß wird das Isoliermaterial auf der ersten und/oder zweiten Außenoberfläche des Grundkörpers elektrophoretisch abgeschieden. Hierfür wird im Verfahrensschritt b) und gegebenenfalls im Verfahrensschritt b') an die ersten internen Elektroden ein erstes elektrisches Potenzial und an die zweiten internen Elektroden ein zweites elektrisches Potenzial angelegt, wobei das erste elektrische Potenzial und das zweite elektrische Potenzial gegensätzlicher Polarität sind. Beispielsweise kann für das erste elektrische Potenzial ein positives Potenzial und für das zweite elektrische Potenzial ein negatives Potenzial ausgewählt werden. Alternativ kann für das erste elektrische Potenzial ein negatives Potenzial und für das zweite elektrische Potenzial ein positives Potenzial ausgewählt werden.

Im Verfahrensschritt b) und/oder b') wird ein drittes elektrisches Potenzial an zumindest eine, mit den ersten und zweiten internen Elektroden in Bezug stehenden Gegenelektrode angelegt. In dieser Ausführungsform werden im Verfahrensschritt b) das erste und das dritte elektrische Potenzial mit gegensätzlicher Polarität sowie der Betrag des dritten elektrischen Potenzials größer als der Betrag des zweiten elektrischen Potenzials gewählt. Entsprechend werden gegebenenfalls im Verfahrensschritt b') das zweite elektrische Potenzial und das dritte elektrische Potenzial mit gegensätzlicher Polarität sowie das dritte elektrische Potenzial mit einem Betrag größer als der Betrag des ersten elektrischen Potenzials gewählt.

Erfindungsgemäß besteht somit die größte Potenzialdifferenz im Verfahrensschritt b) zwischen den ersten internen Elektroden und der Gegenelektrode und im Verfahrensschritt b') zwischen den zweiten internen Elektroden und der Gegenelektrode. Das elektrische Feld, welches durch diese Potenzialdifferenz generiert wird, ist erfindungsgemäß maßgebend für die Bewegungsrichtung des elektrophoretisch mobilen Isoliermaterials sowie dessen Abscheidung im Verfahrensschritt b) an den ersten Außenkanten beziehungsweise in Verfahrensschritt b') an den zweiten Außenkanten. Das bezüglich der Gegenelektrode im Betrag kleiner gewählte elektrische Potenzial EP2 im Verfahrensschritt b) beziehungsweise das elektrische Potenzial EP1 im Verfahrensschritt b') haben jeweils die gleiche Polarität wie das Potenzial der Gegenelektrode. Gleichzeitig werden die Beträge dieser Potenziale so gewählt, dass die Bewegung des elektrophoretisch mobilen Isoliermaterials im Fernfeld, das heißt entlang des elektrischen Feldes zwischen den ersten internen Elektroden und der Gegenelektrode im Verfahrensschritt b) beziehungsweise den zweiten internen Elektroden und der Gegenelektrode im Verfahrensschritt b') nicht unterbunden wird. Im Nahfeld, das heißt in der Nähe der Außenkanten der internen Elektroden auf den Außenoberflächen wird das elektrophoretisch mobile Isoliermaterial jedoch im Verfahrensschritt b) von den zweiten Außenkanten hin zu den ersten Außenkanten beziehungsweise im Verfahrensschritt b') von den ersten Außenkanten hin zu den zweiten Außenkanten abgelenkt. Auf diese Weise wird über die erfindungsgemäße Wahl der Potenziale die strukturierte Abscheidung des elektrophoretisch mobilen Isoliermaterials im Wesentlichen an den ersten Außenkanten in Verfahrensschritt b) und an den zweiten Außenkanten in Verfahrensschritt b') besonders vorteilhaft erreicht, während die zweiten Außenkanten in b) beziehungsweise die ersten Außenkanten in b') zumindest teilweise freiliegend bleiben. Die Spannungsdifferenz zwischen den ersten und zweiten internen Elektroden im Verfahrensschritt b) beziehungsweise b') wird beispielsweise nicht größer als 50 V und vorzugsweise nicht größer als 30 V gewählt. Zum Beispiel können in bestimmten Ausführungsformen die in den Verfahrensschritten b) oder b')zur Abscheidung vorgesehenen internen Elektroden mit 20-100 V, vorzugsweise 30-80 V, bevorzugt 40-70 V beaufschlagt werden. Entsprechend können die internen Elektroden, an denen kein Isoliermaterial abgeschieden werden soll, beispielsweise mit einer Spannung von 0-60 V, vorzugsweise 10-50 V, bevorzugt mit 20-40 V beaufschlagt werden. Die Gegenelektrode kann beispielsweise mit 0 V beaufschlagt werden. Beispielsweise werden die zur Abscheidung vorgesehenen internen Elektroden mit 100 V, die die internen Elektroden, an denen kein Isoliermaterial abgeschieden werden soll, mit 50 V und die Gegenelektrode mit 0 V beaufschlagt. In einer weiteren Ausgestaltung werden beispielsweise die zur Abscheidung vorgesehenen internen Elektroden mit 60 V, die internen Elektroden, an denen kein Isoliermaterial abgeschieden werden soll, mit 30 V und die Gegenelektrode mit 0 V beaufschlagt.

Gemäß einer Weiterbildung der Erfindung ist das Verfahren so ausgestaltet, dass in einem weiteren Verfahrensschritt d) nach dem Verfahrensschritt b) zumindest eine erste elektrische Außenkontaktierung auf zumindest der ersten Außenoberfläche des Grundkörpers aufgetragen wird. In einer bevorzugten Ausführungsform wird die elektrische Außenkontaktierung großflächig auf der ersten Außenoberfläche über der isolierenden Schicht der ersten Außenkanten und den zumindest teilweise freiliegenden zweiten Außenkanten aufgetragen. Beispielsweise kann die elektrische Außenkontaktierung mittels Sputtern aufgebracht werden. Alternativ kann die elektrische Außenkontaktierung als Metallpaste aufgebracht werden, welche anschließend eingebrannt wird. Beispielsweise kann die Metallpaste im Siebdruckverfahren aufgebracht werden. Alternativ kann die elektrische Außenkontaktierung einen Leimkleber aufweisen. Die erste elektrische Außenkontaktierung kann beispielsweise ein elektrisch leitfähiges, beispielsweise ein metallhaltiges oder ein metallisches, Material aufweisen. Vorzugsweise ist die erste elektrische Außenkontaktierung als Schicht aufgetragen. Alternativ kann die erste elektrische Außenkontaktierung aber auch strukturiert aufgetragen werden. Vorzugsweise ist die erste elektrische Außenkontaktierung so angeordnet, dass sie einen elektrischen Sammelkontakt für die zweiten internen Elektroden über die elektrische Kontaktierung der zweiten Außenkanten auf der ersten Außenoberfläche herstellt.

Gemäß einer bevorzugten Ausgestaltung des Verfahrens wird darüber hinaus in einem weiteren Verfahrensschritt d') nach dem Verfahrensschritt b') zumindest eine zweite elektrische Außenkontaktierung auf zumindest der zweiten Außenoberfläche des Grundkörpers aufgetragen. Insbesondere wird die zweite elektrische Außenkontaktierung derart aufgetragen, dass ein elektrischer Sammelkontakt für die ersten internen Elektroden über deren erste Außenkanten auf der zweiten Außenoberfläche hergestellt wird.

Insbesondere können die Verfahrensschritte d) und gegebenenfalls d') auch nach dem Verfahrensschritt c) erfolgen. Es kann in bestimmen Ausgestaltungen des Verfahrens auch ein weiterer Verfahrensschritt c') vorhanden sein, wenn im Verfahrensschritt c) aus dem Isoliermaterial nur auf den ersten Außenkanten und im weiteren Verfahrensschritt c') aus dem Isoliermaterial nur auf den zweiten Außenkanten eine isolierende Schicht erzeugt wird. Beispielsweise kann das Verfahren derart ausgestaltet werden, dass zunächst die Verfahrensschritte b), c) und d) erfolgen und anschließend die Verfahrensschritte b'), c') und d'). In einer alternativen Ausgestaltung können die Verfahrensschritte in der Folge b) und b'), c), d) und d') erfolgen. Beispielsweise können die Verfahrensschritte auch in der Folge der Verfahrensschritte b) und c), b') und c'), d) und d') erfolgen. In einer weiteren Ausgestaltung ist die Abfolge der Verfahrensschritte b) und b'), d) und d'), c) vorgesehen. Weitere Ausgestaltungsmöglichkeiten hinsichtlich der Abfolge der Verfahrensschritte sind vorgesehen und für den Fachmann leicht ersichtlich.

Besondere Vorteile des erfindungsgemäßen Verfahrens ergeben sich dadurch, dass die Abscheidung des Isoliermaterials beziehungsweise der daraus erzeugten isolierenden Schichten durch das erfindungsgemäße Verfahren mittels Elektrophorese strukturiert erfolgt. Daher ist es beispielsweise nicht erforderlich, für die Verfahrenschritte d) oder d') die genaue Position der isolierenden Schicht beziehungsweise der zur Kontaktierung vorgesehenen freiliegenden Außenkanten auf einer Außenoberfläche zu bestimmen. Zum Beispiel können daher die elektrischen Außenkontaktierungen mit besonders einfachen Mitteln großflächig auf den jeweiligen Außenoberflächen aufgetragen werden. Eine gezielte Auftragung der elektrischen Außenkontaktierung an vorgegebenen Stellen auf der Außenoberfläche kann entfallen. Ebenfalls ist aufgrund der elektrophoretisch strukturierten Anordnung des Isoliermaterials beispielsweise das Abtragen von Isoliermaterial an vorgegebenen Stellen für die elektrische Kontaktierung von ersten oder zweiten Außenkanten nicht erforderlich. Ebenfalls kann das Verfahren dadurch aufwendige apparative Anordnungen und Präzisionsinstrumente wie beispielsweise Positionsgeber, Ansteuerungsregler und hochgenaue Schrittmotoren entbehren.

Ein weiterer Vorteil des erfindungsgemäßen Verfahrens ist, dass aufgrund der elektrophoretisch strukturierten Abscheidung des Isoliermaterials Produktionstoleranzen des Grundkörpers inhärent kompensiert werden können. Eine individuelle Anpassung des Verfahrens an den Grundkörper für die Verfahrensschritte b) und oder b') beziehungsweise d) und oder d') kann beispielsweise entfallen. Beim Herstellungsprozess des Grundkörpers kann es zum Beispiel aufgrund von Produktionstoleranzen dazu kommen, dass die Abstände zwischen den internen Elektroden unterschiedlich sind. Solche unterschiedlichen Abstände können beispielsweise durch Pressverzug oder unterschiedlichen Sinterschwund während der Herstellung des Grundkörpers verursacht werden. Dadurch besteht bei im Stand der Technik bekannten Verfahren die Gefahr, dass die internen Elektroden auf einer Außenoberfläche des Grundkörpers nicht ausreichend mit Isoliermaterial beziehungsweise mit elektrischer Außenkontaktierung bedeckt werden. Dadurch besteht die Gefahr von Kurzschlüssen und/oder Fehlkontaktierungen. Solche fehlerhaften Bauelemente müssen üblicherweise durch eine elektrische Messung identifiziert und aussortiert werden. Durch das erfindungsgemäße Verfahren ist eine zuverlässige Isolierung beziehungsweise elektrische Kontaktierung von den jeweils ersten oder zweiten Außenkanten auf den Außenoberflächen des Grundkörpers gewährleistet. Dadurch können elektrische Außenkontaktierungen des Bauelements, bei denen beispielsweise ein oder mehrere erste interne Elektroden oder ein oder mehrere zweite interne Elektroden nicht kontaktiert werden, effektiv vermieden werden. Somit verringert das erfindungsgemäße Verfahren nicht nur den Produktionsausschuss von fehlkontaktierten Bauelementen, sondern erübrigt gleichzeitig aufwendige Qualitätskontrollen im Anschluss an das Herstellungsverfahren.

Die für die Elektrophorese verwendete Zusammensetzung im Verfahrensschritt b) und/oder b') kann beispielsweise Partikel des Isoliermaterials, einen polyionischen Dispergator und Lösungsmittels enthalten. Der polyionische Dispergator erfüllt beispielsweise die Aufgabe, die Partikel des Isoliermaterials unter Bildung des elektrophoretisch mobilen Isoliermaterials in Lösungsmittel zu dispergieren. Beispielsweise kann die gleiche Zusammensetzung in den Verfahrensschritten b) und b') verwendet werden, wenn das erste elektrische Potenzial in Verfahrensschritt b) die gleiche Polarität aufweist wie das zweite elektrische Potenzial im Verfahrensschritt b'). Alternativ kann in den Verfahrensschritten b) und b') eine unterschiedliche Zusammensetzung verwendet werden, wenn das erste elektrische Potenzial im Verfahrensschritt b) und das zweite elektrische Potenzial in Verfahrensschritt b') eine unterschiedliche Polarität aufweisen.

Die Partikel des Isoliermaterials weisen vorzugsweise eine Größe auf, welche durch den polyionischen Dispergator unter Bildung von elektrophoretisch mobilem Isoliermaterial in Lösungsmittel dispergiert werden kann. Vorzugsweise umfassen solche Partikel eine Größe im Bereich von Nanometern bis Mikrometern auf. Vorzugsweise haben die Partikel eine Größe von 10 nm bis 100 µm. Bevorzugt sind Partikel mit einer Korngröße von ca. 0,1 bis 10 µm. Bevorzugt sind weiterhin Partikel mit einer Körngröße von 0,2 bis 5 µm. Besonders bevorzugt sind Partikel, die eine Korngröße von 0,5 bis 2 µm aufweisen.

Der polyionische Dispergator kann beispielsweise einen polyanionischen Dispergator oder einen polykationischen Dispergator umfassen. Beispielsweise können polyanionische oder polykationische organische Polymere verwendet werden. Als polykationischer Dispergator kann zum Beispiel poly(diallyl-dimethyl)-ammoniumchlorid (PDADMAC) oder Polyethylenimin verwendet werden. Geeignete Polykationen sind dem Fachmann bekannt oder aus dem Stand der Technik ersichtlich. Vorzugsweise wird als polykationischer Dispergator PDADMAC verwendet. Als polyanionische Dispergatoren können beispielsweise Polyphosphate, Polycarbonsäuren oder Polysulfonsäuren verwendet werden. Beispielsweise kann Polyacrylsäure verwendet werden. Weitere geeignete Polykationen sind dem Fachmann bekannt oder aus dem Stand der Technik ersichtlich.

Neben polyionischen Dispergatoren können auch ionische Tenside verwendet werden, welche die Partikel des Isoliermaterials unter Bildung des elektrophoretisch mobilen Isoliermaterials in Lösungsmittel zu dispergieren vermögen. Als ionische Tenside können zum Beispiel anionische Tenside verwendet werden. Beispielsweise kann Natriumdodecylsulfat (SDS) verwendet werden. In weiteren Ausführungsformen können auch kationischen Tenside verwendet werden. Beispielsweise können Tenside mit quartären Ammoniumverbindungen wie zum Beispiel Distearyldimethylammoniumchlorid (DSDMAC) verwendet werden.

Vorzugsweise wird ein polyionischer Dispergator oder alternativ ein ionisches Tensid so ausgewählt, dass ein Benetzen der Partikel des Isoliermaterials gewährleistet ist. Durch den polyionischen Dispergator oder das ionische Tensid werden die Partikel des Isoliermaterials vorzugsweise mit einer Oberflächenladung ausgestattet, so dass aufgrund der elektrostatischen Repulsion zwischen den Partikeln des Isoliermaterials die Partikel keine Agglomerate bilden. Vorzugsweise wird der polyionische Dispergator oder das ionische Tensid so ausgewählt, dass die Partikel des Isoliermaterials mit einer Nettoladung ausgestattet werden, beispielsweise um die elektrisch geladenen Partikel des Isoliermaterials durch ein elektrisches Feld antreiben zu können.

Als Lösungsmittel können beispielsweise wässrige Lösungsmittel oder organische Lösungsmittel eingesetzt werden. Beispielsweise können Wasser oder wässrige Puffer verwendet werden. Als organische Lösungsmittel können beispielsweise Ethanol, Methyl-Ethylketon oder Butylacetat verwendet werden. Alternativ können beispielsweise Mischungen aus wässrigen und organischen Lösungsmitteln eingesetzt werden.

Gemäß einer Weiterbildung des erfindungsgemäßen Verfahrens sind die Partikel des Isoliermaterials so ausgewählt, dass sie Partikel zumindest eines elektrisch isolierenden Materials aus der Gruppe Glas, Keramik, temperaturbeständiger Kunststoff oder Kombinationen davon umfassen. Beispielsweise kann das elektrisch isolierende Material Glas sein. Das elektrisch isolierende Material kann beispielsweise Blei-Silikat-Glas sein. Alternativ kann das elektrisch isolierende Material keramisches Material sein. Beispielsweise kann das keramische Material eine Sinterkeramik sein, zum Beispiel Aluminiumoxid. Das elektrisch isolierende Material kann auch ein temperaturbeständiger Kunststoff sein. Beispielsweise kann der temperaturbeständige Kunststoff ein organisches elektrisch isolierendes Material sein, zum Beispiel ein organisches Polymer oder Copolymer. Insbesondere kann das organische elektrisch isolierende Material ein Polyolefin, Polyisiloxan, Polyamid, Polyester, Polystyrol, Polyether oder Polyvinylchlorid beinhalten.

In bestimmten Ausführungsformen umfasst der polyionische Dispergator oder das ionische Tensid insbesondere einen polyanionischen Dispergator oder ein anionisches Tensid, wenn im Verfahrensschritt b) die ersten internen Elektroden und gegebenenfalls im Verfahrensschritt b') die zweiten internen Elektroden als Anode geschaltet sind. Dadurch wandert das elektrophoretisch mobile Isoliermaterial gemäß seiner negativen Nettoladung zu den als Pluspol geschalteten Elektroden. In einer weiteren Ausführungsform der Erfindung umfasst der polyionische Dispergator oder das ionische Tensid einen polykationischen Dispergator oder ein kationisches Tensid, wenn im Verfahrensschritt b) die ersten internen Elektroden und gegebenenfalls im Verfahrensschritt b') die zweiten internen Elektroden als Kathode geschaltet sind. Auf diese Weise wandert das elektrophoretisch mobile Isoliermaterial gemäß seiner positiven Nettoladung zu den als Minuspol geschalteten Elektroden.

In einer weiteren Ausführungsform des erfindungsgemäßen Verfahrens wird ein Grundkörper verwendet, welcher ein piezokeramisches Material umfasst. Das piezokeramische Material kann beispielsweise Blei-Zirkonat-Titanat (PZT) enthalten. Alternativ kann das piezokeramische Material eine bleifreie Keramik enthalten. Das piezokeramische Material kann beispielsweise auch Dotierstoffe enthalten. Der Grundkörper kann beispielsweise piezokeramische Schichten umfassen. Das keramische Bauelement kann beispielsweise als piezoelektrisches Bauelement in Vielschichtbauweise, zum Beispiel als Piezoaktuator, ausgebildet werden. Bei einem Piezoaktuator sind typischerweise die internen Elektroden als Elektrodenschichten übereinander angeordnet, wobei sich zwischen den Elektrodenschichten eine piezoelektrische Schicht befindet. Dabei kann eine piezoelektrische Schicht aus einer oder mehreren piezoelektrischen Lagen gebildet sein. Eine piezoelektrische Schicht kann auch nur eine einzige piezoelektrische Lage aufweisen. Durch das Anlegen einer Spannung an die internen Elektrodenschichten dehnen sich die piezoelektrischen Schichten zwischen gegensätzlich gepolten Elektrodenschichten aus, so dass ein Hub des Piezoaktuators erzeugt wird. Das keramische Bauelement kann aber auch als ein anderes Bauelement ausgebildet sein, beispielsweise als ein Mehrlagen- oder Vielschichtkondensator, welches beispielsweise eine andere Anordnung der internen Elektroden aufweist.

Das keramische Bauelement ist vorzugsweise ein in Vielschicht-Technologie gefertigtes, voll-aktives Bauelement. Bei einem voll-aktiven Bauelement erstrecken sich die internen Elektroden typischer Weise als interne Elektrodenschichten über den gesamten Querschnitt des Grundkörpers, so dass die keramischen Schichten von den internen Elektrodenschichten vollflächig bedeckt werden. Das Bauelement ist somit insbesondere frei von inaktiven Zonen zwischen benachbarten Elektrodenschichten. Als inaktive Zone wird hierbei ein Bereich zwischen zwei benachbarten Elektrodenschichten unterschiedlicher Polarität verstanden, in dem sich die Elektrodenschichten nicht überlappen. In solchen piezoelektrisch inaktiven Zonen liegt üblicherweise eine andere Ausdehnung der piezoelektrischen Schichten als in den piezoelektrisch aktiven Zonen vor, die zu mechanischen Spannungen und in der Regel zur Rissbildung führen kann. Die Rissbildung im Bauelement muss üblicherweise durch aufwendige bautechnische Lösungen kompensiert werden. Beispielsweise werden Zwischenschichten zusätzlich zu den piezoelektrischen Schichten eingebaut, welche leichter reißen und dadurch eine gewisse Steuerung der Rissbildung ermöglichen. Nachteilig ist, dass durch den Einbau von Zwischenschichten ein Verlust an aktiver Länge des piezoelektrischen Bauelements entsteht. Inaktive Zonen sowie der Verlust von aktiver Länge führen gleichermaßen zu einem Verlust an aktiver Fläche und wirken sich somit nachteilig auf die piezoelektrische Dehnung beziehungsweise Blockierkraft des Bauelements aus. Entsprechend resultiert ein erhöhter Platzbedarf von Bauelementen mit inaktiven Zonen, um den Verlust des Hubvermögens und der Blockierkraft zu kompensieren. Inaktive Zonen treten beispielsweise bei herkömmlichen Herstellungsverfahren auf, wenn zum Zweck der selektiven elektrischen Kontaktierung von Elektrodenschichten diese nicht vollständig auf die entsprechende keramische Schicht gedruckt werden, sondern von zumindest einer Außenkontaktseite elektrisch isolierend beabstandet sind. Solche inaktiven Zonen treten bei der vorliegenden Erfindung nicht auf, da sich die isolierende Schicht erfindungsgemäß auf den Außenoberflächen der Bauelemente befindet und somit die elektrisch isolierende Beabstandung ersetzt, so dass die Elektrodenschichten vollflächig auf die keramischen Schichten gedruckt werden können.

In einer bevorzugten Ausführungsform des Verfahrens wird im Verfahrensschritt a) eine Grundkörperanordnung umfassend den keramischen Grundkörper bereitgestellt, wobei die Anordnung zusätzlich eine dritte Außenoberfläche und eine vierte Außenoberfläche aufweist. In dieser bevorzugten Anordnung befinden sich die ersten Außenkanten der ersten internen Elektroden zusätzlich auf der dritten Außenoberfläche und liegen von der vierten Außenoberfläche durch eine erste Isolationszone beabstandet vor. Die zweiten Außenkanten der zweiten internen Elektroden befinden sich in der Anordnung auf der vierten Außenoberfläche und liegen von der dritten Außenoberfläche durch eine zweite Isolationszone beabstandet vor. Üblicherweise weisen die Isolationszonen das gleiche piezoelektrische Material wie der Rest des Grundkörpers auf. Beispielsweise handelt es sich bei der dritten und vierten Außenoberfläche um gegenüberliegende Außenseiten des Grundkörpers. Alternativ kann es sich bei der dritten und vierten Außenoberfläche auch um benachbarte Außenseiten des Grundkörpers handeln.

Die Isolationszonen bewirken eine elektrisch isolierende Beabstandung der ersten Außenkanten von der vierten Außenoberfläche beziehungsweise der zweiten Außenkanten von der dritten Außenoberfläche. Beispielsweise können die Isolationszonen eine Breite zwischen 0,1 und 1 mm aufweisen. Vorzugsweise ist die Breite der Isolationszonen zwischen 0,4 und 0,9 mm. Üblicherweise wird die Breite der Isolationszonen in Abhängigkeit von der Baugröße der Anordnung sowie den Fertigungstoleranzen gewählt.

Gemäß einer bevorzugten Ausführungsform wird durch eine erste vorläufige Außenkontaktierung auf der dritten Außenoberfläche der Anordnung ein vorläufiger elektrischer Kontakt mit den ersten Außenkanten hergestellt. Die zweiten Außenkanten werden aufgrund der zweiten Isolationszone durch die erste vorläufige Außenkontaktierung nicht elektrisch kontaktiert. Durch eine zweite vorläufige Außenkontaktierung auf der vierten Außenoberfläche wird ein elektrischer Kontakt mit den zweiten Außenkanten hergestellt. Die ersten Außenkanten werden aufgrund der ersten Isolationszone durch die zweite vorläufige Außenkontaktierung nicht elektrisch kontaktiert. Durch diese bevorzugte Ausführungsform ist es möglich, die ersten internen Elektroden mit dem ersten elektrischen Potenzial und/oder die zweiten internen Elektroden mit dem zweiten elektrischen Potenzial selektiv zu belegen.

Beispielsweise kann die Grundkörperanordnung zumindest zwei oder eine Mehrzahl der keramischen Grundkörper umfassen. Beispielsweise kann in einem abschließenden Verfahrensschritt die Grundkörperanordnung in einzelne, vorzugsweise voll-aktive, keramische Bauelemente getrennt werden, wobei auch die erste und zweite Isolationszone entfernt werden. Dieses Verfahren hat den Vorteil, dass durch die Grundkörperanordnung nur eine erste und eine zweite Isolationszone für die selektive elektrische Kontaktierung der ersten und zweiten Außenkanten einer Mehrzahl von Grundkörpern erforderlich sind. Auf diese Weise wird beispielsweise der Schnittverlust bei der anschließenden Trennung in voll-aktive Bauelemente gegenüber herkömmlichen Verfahren reduziert, bei denen zum Beispiel jeder einzelne Grundkörper eine erste und eine zweite Isolationszone aufweist, welche anschließend entfernt werden müssen.

Nach der Abscheidung des Isoliermaterials auf den ersten Außenkanten der ersten Außenoberfläche wird der Grundkörper üblicherweise getrocknet. Anschließend kann die Abscheidung gegebenenfalls auf den zweiten Außenkanten der zweiten Außenseite wiederholt werden. Nachfolgend kann die Abscheidung beispielsweise entkohlt und ausgebrannt werden. Das Entkohlen kann in Abhängigkeit vom Material und der Prozesssteuerung beispielsweise bei einer Temperatur von 400-500 °C für 0,5-3 Stunden erfolgen. Das Einbrennen kann in Abhängigkeit vom Material und der Prozesssteuerung beispielsweise bei einer Temperatur von 700-900 °C über 0,5-3 Stunden erfolgen, wobei die isolierende Schicht gebildet wird. In bevorzugten Ausführungsformen erfolgt beispielsweise das Entkohlen bei 450 °C für 0,5-1 h und das Einbrennen über eine Temperaturrampe mit 0,5 h Haltezeit bei 800 °C.

Eine weitere Ausführungsform der Erfindung betrifft ein keramisches Bauelement, welches einen Grundkörper mit internen Elektroden aufweist. Die internen Elektroden umfassen zumindest eine erste interne Elektrode mit ersten Außenkanten und zumindest eine zweite interne Elektrode mit zweiten Außenkanten. Diese ersten und zweiten Außenkanten befinden sich zumindest auf einer ersten und einer zweiten Außenoberfläche des Grundkörpers. Weiterhin weist das keramische Bauelement eine elektrisch isolierende Schicht auf, welche sich auf den Außenkanten der internen Elektroden auf der ersten und zweiten Außenoberfläche befindet. Hierbei befindet sich die isolierende Schicht auf der ersten Außenoberfläche im Wesentlichen nur auf den ersten Außenkanten und nicht auf den zweiten Außenkanten und auf der zweiten Außenoberfläche im Wesentlichen nur auf den zweiten Außenkanten und nicht auf den ersten Außenkanten. Die strukturierte Anordnung des Isoliermaterials ist mittels Elektrophorese realisiert. Vorzugsweise wird das keramische Bauelement gemäß dem oben beschriebenen Verfahren hergestellt und weist die Vorteile eines mit diesem Verfahren hergestellten keramischen Bauelements auf.

Gemäß einer weiteren Ausgestaltung ist die isolierende Schicht aufgrund des elektrophoretischen Abscheideverfahrens in Stegen auf den Außenkanten der internen Elektroden strukturiert. Aufgrund der erfindungsgemäßen elektrophoretischen Strukturierung sind die Stege im Querschnitt schmaler als der doppelte Abstand zwischen benachbarten Außenkanten. Durch das Erzeugen der isolierenden Schicht aus der elektrophoretischen Abscheidung von Partikeln des Isolierstoffs durch Einbrennen weisen die Stege der isolierenden Schicht einen abgerundeten Querschnitt auf Vorzugsweise ist das keramische Bauelement durch ein wie oben beschriebenes Verfahren hergestellt. Durch das elektrophoretische Verfahren ist gewährleistet, dass die zweiten Außenkanten auf der ersten Außenoberfläche elektrisch kontaktiert werden können und die ersten Außenkanten auf der zweiten Außenoberfläche elektrisch kontaktiert werden können. Vorzugsweise ist eine Vorstrukturierung der Außenkanten und/oder der Außenoberfläche für die Strukturierung der isolierenden Schicht, beispielsweise durch Lithografie oder Abtragung, nicht erforderlich. Vorzugsweise ist auch eine Nachstrukturierung der isolierenden Schicht, beispielsweise durch Abtragen der isolierenden Schicht über den Außenkanten der internen Elektroden für die elektrische Kontaktierung, nicht erforderlich. Vorzugsweise weist das keramische Bauelement daher keine Merkmale einer solchen Vor- oder Nachstrukturierung auf. Aufgrund des elektrophoretischen Verfahrens kann zumindest ein Teil der Partikel des Isoliermaterials nach dem Erzeugen der isolierenden Schicht in dieser nachweisbar bleiben. Beispielsweise kann auch ein Teil des polyionischen Dispergators oder des ionischen Tensids nach dem Erzeugen der isolierenden Schicht in dieser verbleiben.

Eine weitere Ausführungsform der Erfindung betrifft ein keramisches Bauelement, welches durch das oben genannte erfindungsgemäße Verfahren erhältlich ist.

### Figuren

Im Folgenden werden das Verfahren zur Herstellung eines keramischen Bauelements sowie das keramische Bauelement anhand von schematischen und nicht maßstabsgetreuen Figuren beispielhaft erläutert. Einzelne ausgewählte Elemente der Figuren können zur besseren Kenntlichmachung durch Bezugszeichen benannt sein, wobei wiederkehrende Elemente aus Gründen der Übersichtlichkeit unter Umständen nicht mehrfach benannt sind.
Figur 1 zeigt ein Ausführungsbeispiel für erste und zweite Grünfolien.
Figur 2 zeigt ein Ausführungsbeispiel für eine Grundkörperanordnung.
Figur 3 zeigt eine Anordnung für die elektrophoretische Abscheidung des Isolierstoffes.
Figur 4A zeigt in einer Schnittansicht das Bauelement in einem Zwischenzustand des Verfahrens nach Verfahrensschritt b) nach dem elektrophoretischen Abscheiden von Isoliermaterial.
Figur 4B zeigt in einer Schnittansicht das Bauelement in einem weiteren Zwischenzustand nach des Verfahrens nach Verfahrensschritt c) nach dem Erzeugen der isolierenden Schicht.
Figur 4C zeigt in einer Schnittansicht das Bauelement in einem weiteren Zwischenzustand des Verfahrens Verfahrensschritt d) nach dem Aufbringen einer Außenmetallisierung.

### Ausführungsbeispiel

Das folgende Beispiel dient dem Zweck der Erläuterung der Erfindung und nicht der Limitierung auf spezifische Details.

### Herstellung eines voll-aktiven Piezo-Aktuator Bauelements

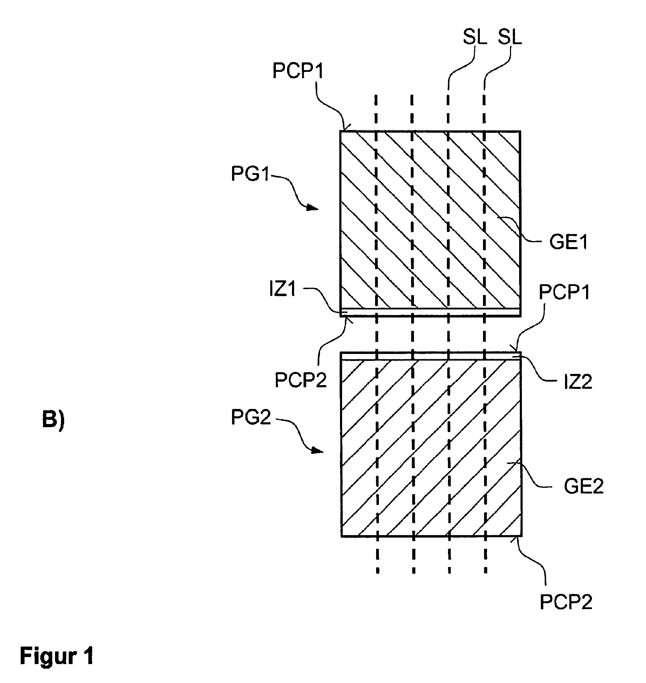

Die Figur 1 zeigt erste und zweite keramische Grünfolien (PG1, PG2), welche zur Herstellung eines voll-aktiven Piezo-Aktuator Bauelements alternierend verstapelt werden. Die ersten und die zweiten Grünfolien sind nahezu vollflächig mit internen Elektroden in Form von ersten und zweiten Elektrodenschichten bedruckt (GE1, GE2), wobei nur eine erste schmale Isolationszone (IZ1) angrenzend an eine zweite vorläufige Außenkontaktseite (PCP2) von den ersten Elektrodenschichten (GE1) beziehungsweise eine zweite schmale Isolationszone (IZ2) angrenzend an eine erste vorläufige Außenkontaktseite (PCP1) von den zweiten Elektrodenschichten (GE2) ausgespart bleiben. Typischerweise haben diese Isolationszonen eine Breite zwischen 0,4 und 0,9 mm. Die ersten Elektrodenschichten (GE1) sind auf die erste vorläufige Außenkontaktseite (PCP1) herausgezogen, während die zweiten Elektrodenschichten (GE2) auf die zweite vorläufige Außenkontaktseite (PCP2) herausgezogen sind. Die Grünfolien enthalten beispielsweise ein Keramikpulver, ein organisches Bindemittel und ein Lösungsmittel, und können durch Folienziehen oder Foliengießen hergestellt werden. Das Keramikpulver kann beispielsweise ein piezokeramisches Material, beispielsweise Blei-Zirkonat-Titanat (PZT) oder eine bleifreie Keramik umfassen. Die Elektrodenschichten können beispielsweise als Metallpaste im Siebdruckverfahren aufgedruckt werden. Die Metallpaste kann beispielsweise Kupfer oder Silber-Palladium enthalten, so dass interne Elektroden als interne Elektrodenschichten gebildet werden, welche Kupfer oder Silber-Palladium als Hauptbestandteil enthalten.

Die ersten und zweiten Grünfolien (PG1, PG2) werden anschließend abwechselnd übereinander gestapelt, so dass die ersten Isolationszonen (IZ1) auf der Seite der zweiten vorläufigen Außenkontaktseite (PCP2) und die zweiten Isolationszonen (IZ2) auf der ersten vorläufigen Außenkontaktseite (PCP1) liegen. Anschließend wird der Stapel gepresst und entlang der schematisiert gezeigten Trennlinien (SL) getrennt und gesintert, so dass eine oder mehrere Grundkörperanordnungen (SBA) bereitgestellt werden.

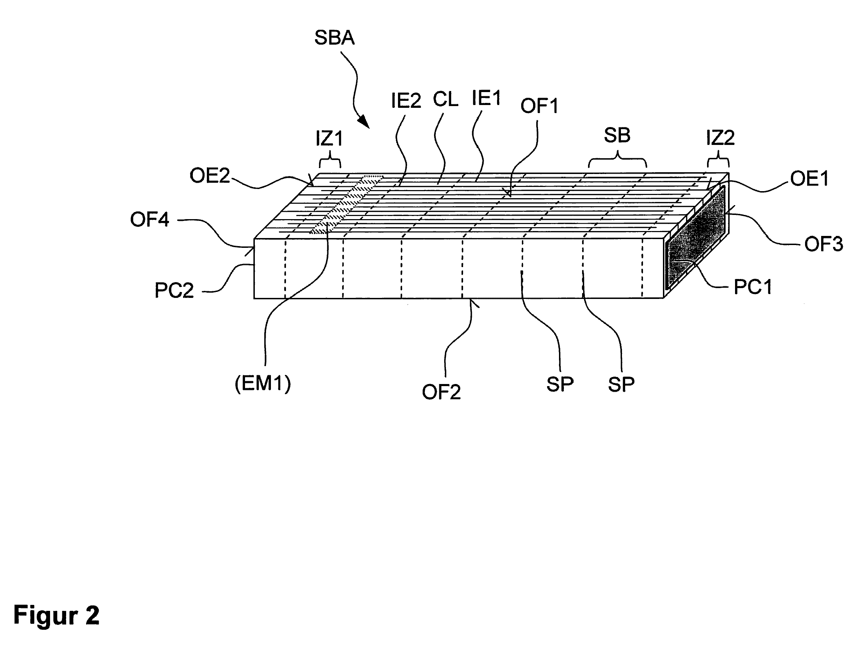

Figur 2 zeigt eine Grundkörperanordnung (SBA), anhand derer das weitere Verfahren beispielhaft erläutert wird. Die Anordnung ist als monolithischer Sinterkörper in Vielschicht-Technologie ausgebildet. Die keramischen Schichten (CL) und die internen Elektroden (IE1, IE2) sind entlang einer Stapelrichtung übereinander angeordnet. Dabei sind erste interne Elektroden (IE1) und zweite interne Elektroden (IE2) zwischen den keramischen Schichten (CL) abwechselnd übereinander angeordnet. Die ersten Außenkanten (OE1) der ersten internen Elektroden (IE1) sind auf eine dritte Außenoberfläche (OF3) herausgezogen und dort durch eine erste vorläufige Außenkontaktierung (PC1) gesammelt elektrisch kontaktiert. Die dritte Außenoberfläche (OF3) entspricht somit der Seite der ersten vorläufigen Außenkontaktseite (PCP1). Die zweiten Außenkanten (OE2) der zweiten internen Elektroden (IE2) sind von der dritten Außenoberfläche (OF3) durch die zweite Isolationszone (IZ2) elektrisch isolierend beabstandet. Die zweiten Außenkanten (OE2) der zweiten internen Elektroden (IE2) sind auf eine vierte Außenoberfläche (OF4) herausgezogen und durch eine zweite vorläufige Außenkontaktierung (PC2) gesammelt elektrisch kontaktiert. Die vierte Außenoberfläche (OF4) entspricht somit der Seite der zweiten vorläufigen Außenkontaktseite (PCP2). Die ersten Außenkanten (OE1) liegen von der vierten Außenoberfläche (OF4) durch die erste Isolationszone (IZ1) elektrisch isolierend beabstandet vor. Die ersten und zweiten Außenkanten (OE1, OE2) befinden sich auf einer ersten Außenoberfläche (OF1) und einer zweiten Außenoberfläche (OF2).

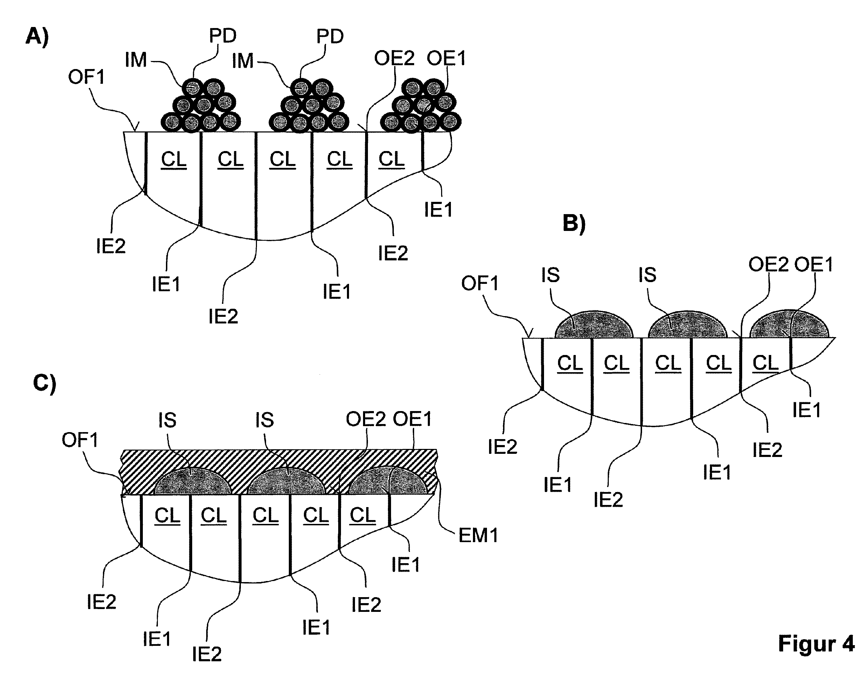

Darüber hinaus ist in Figur 2 eine erste Außenkontaktierung (EM1) beispielhaft angedeutet. Schematische Trennlinien (SP) zeigen beispielhaft an, an welchen Stellen die Grundkörperanordnung in einem späteren Verfahrensschritt nach dem Aufbringen der Außenkontaktierung in einzelne Grundkörper (SB) getrennt werden kann. Die Trennlinien zeigen auch beispielhaft die Schnittebene für die Figuren 4A bis C an.

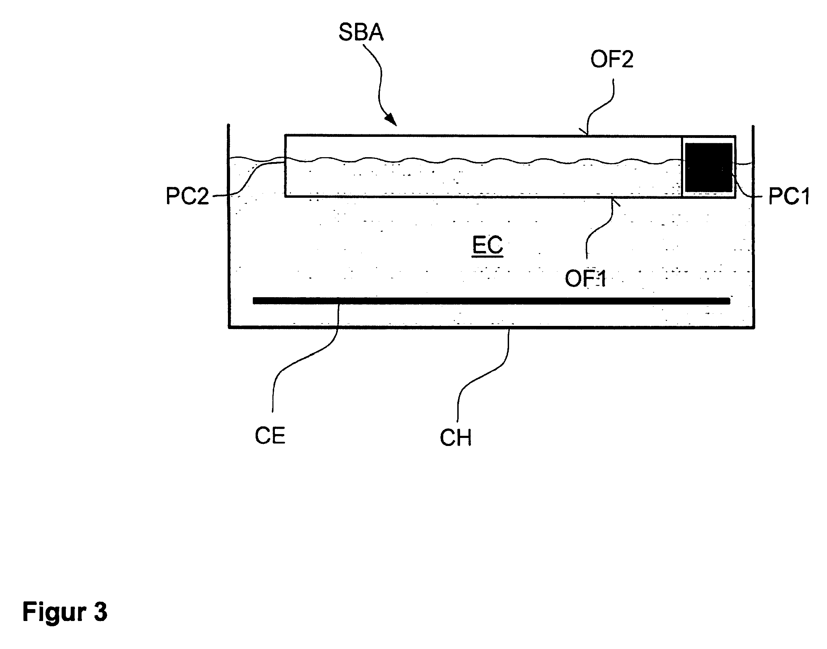

Figur 3 zeigt eine mögliche Anordnung für die elektrophoretische Abscheidung des Isoliermaterials auf den Außenkanten der internen Elektroden auf den Außenoberflächen des Grundkörpers (SB) beziehungsweise der Grundkörperanordnung (SBA). Die Anordnung weist eine Kammer (CH) auf, welche die Zusammensetzung (EC) umfassend ein elektrophoretisch mobiles Isoliermaterial (IM) enthält. Als Isoliermaterial wird fein gemahlenes Pulver aus Blei-Silikat-Glas mit einer Partikelgröße von circa ein bis zwei Mikrometern eingesetzt. Durch Zusatz von polykationischem poly(diallyl-dimethyl)-ammoniumchlorid (PDADMAC) werden die Glaspartikel im Lösungsmittel Wasser oder Ethanol dispergiert und erhalten eine positive Nettoladung, so dass sie durch ein elektrisches Feld angetrieben werden können. Außerdem befindet sich in der Kammer eine Gegenelektrode (CE) im Kontakt mit der Zusammensetzung. Die Gegenelektrode ist beispielsweise eine Elektrode aus Kupfer oder Palladium.

Die in Figur 2 beschriebene Grundkörperanordnung wird zunächst mit der ersten Außenoberfläche (OF1) mit der Zusammensetzung (EC) in Kontakt gebracht. Als nächstes wird ein elektrisches Feld erzeugt, in dem ein negatives erstes elektrisches Potenzial an die ersten internen Elektroden (IE1) über den ersten vorläufigen Außenkontakt (PC1) und ein positives drittes elektrisches Potenzial an die Gegenelektrode (CE) angelegt wird. Über die zweite vorläufige Außenkontaktierung (PC2) wird ein positives zweites elektrisches Potenzial an die zweiten internen Elektroden (IE2) angelegt. Das zweite elektrische Potenzial ist vom Betrag her kleiner gewählt als das dritte elektrische Potenzial. Beispielsweise beträgt die Spannung an der Gegenelektrode 0 V, an den zweiten internen Elektroden 30 V und an den ersten internen Elektroden 60 V. Das elektrophoretisch mobile Isoliermaterial wandert nun entsprechend seiner positiven Nettoladung entlang des elektrischen Feldes zu den negativ polarisierten ersten Außenkanten und wird dort abgeschieden. Das positive zweite elektrische Potenzial bewirkt, dass das elektrophoretisch mobile Material in unmittelbarer Nähe der zweiten Außenkanten elektrisch abgestoßen und zu den ersten Außenkanten hin abgelenkt wird. Auf diese Weise findet eine Abscheidung des elektrophoretisch mobilen Isoliermaterials im Wesentlichen nur an den ersten Außenkanten statt, ohne dass weitere regulierende Schritte wie beispielsweise eine Vor- oder Nachstrukturierung erforderlich sind.

Nach dem Abscheiden des Isoliermaterials an den ersten Außenkanten wird die Grundkörperanordnung getrocknet und das Verfahren entsprechend mit der zweiten Außenoberfläche wiederholt, so dass auf der zweiten Außenoberfläche (OF2) die Abscheidung des Isoliermaterials auf den zweiten Außenkanten stattfindet. Zu diesem Zweck wird die gleiche Zusammensetzung wie für die Beschichtung der ersten Außenkanten verwendet, indem dem ein negatives zweites elektrisches Potenzial an die zweiten internen Elektroden (IE2) über den zweiten vorläufigen Außenkontakt (PC2) und ein positives drittes elektrisches Potenzial an die Gegenelektrode (CE) angelegt wird. Gleichzeitig wird über die erste vorläufige Außenkontaktierung (PC1) ein positives erstes elektrisches Potenzial an die ersten internen Elektroden (IE1) angelegt, welches vom Betrag her kleiner gewählt wird als das dritte elektrische Potenzial. Alternativ könnte aber auch eine andere Zusammensetzung gewählt werden, beispielsweise unter Verwendung eines polyanionischen Dispergators. Zu diesem Zweck kann beispielsweise ein positives zweites elektrisches Potenzial und ein negatives drittes elektrisches Potenzial angelegt werden, sowie ein negatives erstes Potenzial, welches im Betrag kleiner ist als das dritte elektrische Potenzial.

Durch das erfindungsgemäße Verfahren ist eine zuverlässige Isolierung von den jeweils ersten oder zweiten Außenkanten auf den Außenoberflächen des Grundkörpers gewährleistet. Gleichzeitig wird durch die elektrophoretische Strukturierung verhindert, dass bei dieser speziellen Bauart mit alternierenden ersten und zweiten Außenkanten zwei oder mehrere benachbarte Außenkanten mit Isoliermaterial bedeckt werden. Fehlkontaktierungen können auf diese Weise besonders vorteilhaft vermieden werden.

Nach der Abscheidung des Isoliermaterials auf der zweiten Außenoberfläche wird das Isoliermaterial bei 450°C für 1 h entkohlt und anschließend bei 800 °C für 0,5 h haftend eingebrannt. Durch das Einbrennen erhalten die isolierenden Schichten den charakteristischen abgerundeten Querschnitt. Anschließend werden erste elektrische Außenkontaktierungen (EM1) über der isolierenden Schicht der ersten Außenkanten auf der ersten Außenoberfläche sowie zweite elektrische Außenkontaktierungen (EM2) über der isolierenden Schicht der zweiten Außenkanten auf der zweiten Außenoberfläche auf den einzelnen Grundkörpern der Grundkörperanordnung aufgetragen und eingebrannt. Alternativ können die Abscheidungen des Isoliermaterials und die elektrischen Außenkontaktierungen auch in einem gemeinsamen Schritt eingebrannt werden. Anschließend wird die Anordnung in einzelne keramische Bauelemente getrennt. Durch die Trennung liegen die Bauelemente als vollaktiver Piezoaktuator vor, da die internen Elektroden die gesamte Querschnittsfläche des Grundkörpers bedecken, das heißt die piezoelektrischen Schichten sind vollständig von den internen Elektroden bedeckt. Aufgrund der vorteilhaften Grundkörperanordnung entsteht nur ein geringfügiger Schnittverlust bei der Trennung, welcher im Wesentlichen auf die ersten und zweiten Isolationszonen beschränkt bleibt.

Die Figuren 4A bis 4C zeigen jeweils in einer Seitenansicht einen Ausschnitt eines Bauelements in verschiedenen Zwischenzuständen während der Verfahrensschritte b), c) und d). Die Schnittebene entspricht einem Ausschnitt im Bereich der ersten Außenoberfläche (OF1) entlang einer Trennlinie (SP) aus Figur 2. Figur 4A zeigt, wie auf der ersten Außenoberfläche (OF1) die Abscheidung der Partikel des Isoliermaterials (IM) im Verfahrensschritt b) im Wesentlichen auf den Außenkanten der ersten internen Elektroden (IE1) stattgefunden hat, während auf den zweiten Außenkanten der zweiten internen Elektroden (IE2) kein Isoliermaterial abgeschieden wurde. Die Partikel des Isoliermaterials weisen noch polyionischen Dispergator (PD) auf. Figur 4B zeigt den Zwischenzustand im Verfahrensschritt c), nachdem durch das Entkohlen und Einbrennen des Isoliermaterials die isolierende Schicht (IS) über den ersten Außenkanten erzeugt wurde. Die Partikel des Isoliermaterials sind zu Stegen mit abgerundetem Querschnitt mit der ersten Außenoberfläche haftend verschmolzen. Es sind nur die ersten Außenkanten von der isolierenden Schicht elektrisch isolierend bedeckt, während die zweiten Außenkanten freiliegen und für die elektrische Außenkontaktierung kontaktfähig sind. Figur 4C zeigt den Zwischenzustand im Verfahrensschritt d), nachdem die erste Außenkontaktierung (EM1) auf der ersten Außenoberfläche aufgetragen wurde. Die erste Außenkontaktierung befindet sich im elektrischen Kontakt mit den freiliegenden zweiten Außenkanten, während die ersten Außenkanten durch die isolierende Schicht (IS) von der ersten Außenkontaktierung elektrisch isoliert sind.

### Bezugszeichenliste

- PG1: erste Grünfolie
- PG2: zweite Grünfolie
- IZ1: erste Isolationszone
- IZ2: zweite Isolationszone
- GE1: erste Elektrodenschicht
- GE2: zweite Elektrodenschicht
- PCP1: erste vorläufige Außenkontaktfläche
- PCP2: zweite vorläufige Außenkontaktfläche
- PC1: erste vorläufige Außenkontaktierung
- PC2: zweite vorläufige Außenkontaktierung
- SL: schematische Trennlinien für grünen Stapel
- SBA: keramische Grundkörperanordnung
- SB: keramischer Grundkörper
- IE1: erste interne Elektrode
- IE2: zweite interne Elektrode
- OE1: erste Außenkanten
- OE2: zweite Außenkanten
- CL: Keramikschicht
- OF1: erste Außenoberfläche
- OF2: zweite Außenoberfläche
- OF3: dritte Außenoberfläche
- OF4: vierte Außenoberfläche
- SP: schematische Trennlinien für Grundkörperanordnung
- EC: Zusammensetzung umfassend einen elektrophoretisch mobilen Isolierstoff
- IM: Isoliermaterial
- IS: isolierende Schicht
- CE: Gegenelektrode
- EM1: erste elektrische Außenkontaktierung
- EM2: zweite elektrische Außenkontaktierung
- PD: polyionischer Dispergator

## Patentansprüche

1. Verfahren zur Herstellung eines keramischen Bauelements, umfassend die folgenden Verfahrensschritte:
a) Bereitstellen eines Grundkörpers (SB) mit internen Elektroden, wobei die internen Elektroden im Grundkörper zumindest eine erste interne Elektrode (IE1) mit ersten Außenkanten (OE1) und zumindest eine zweite interne Elektrode (IE2) mit zweiten Außenkanten (OE2) umfassen und die ersten und zweiten Außenkanten sich auf zumindest einer ersten Außenoberfläche (OF1) des Grundkörpers befinden,
b) Kontaktieren der ersten Außenoberfläche (OF1) des Grundkörpers mit einer Zusammensetzung (EC) umfassend ein elektrophoretisch mobiles Isoliermaterial (IM) und elektrophoretisches Abscheiden des Isoliermaterials (IM) auf den ersten Außenkanten (OE1) der ersten internen Elektroden auf der ersten Außenoberfläche (OF1) des Grundkörpers und nicht auf den zweiten Außenkanten (OE2) der zweiten internen Elektroden, wobei an die ersten internen Elektroden ein erstes elektrisches Potenzial (EP1) und an die zweiten internen Elektroden ein zweites elektrisches Potenzial (EP2) angelegt wird und wobei EP1 und EP2 gegensätzlicher Polarität sind,
wobei ein drittes elektrisches Potenzial (EP3) an zumindest eine, mit den ersten und zweiten internen Elektroden in Bezug stehende Gegenelektrode (CE) angelegt wird, wobei die Potenziale EP1 und EP3 gegensätzlicher Polarität sind und der Betrag des Potenzials EP3 größer als der Betrag des Potenzials EP2 gewählt wird,
c) Erzeugen einer isolierenden Schicht (IS) aus dem Isoliermaterial auf den Außenkanten der internen Elektroden (IE1, IE2).

2. Verfahren nach Anspruch 1, wobei die ersten und zweiten Außenkanten sich zusätzlich auf zumindest einer weiteren zweiten Außenoberfläche (OF2) des Grundkörpers befinden, wobei in einem nach b) stattfindenden Verfahrensschritt b') die zweite Außenoberfläche (OF2) mit einer Zusammensetzung (EC) kontaktiert wird und wobei das Isoliermaterial auf der zweiten Außenoberfläche (OF2) nur auf den zweiten Außenkanten (OE2) und nicht auf den ersten Außenkanten (OE1) abgeschieden wird.

3. Verfahren nach Anspruch 2, wobei im Verfahrenschritt b') an die ersten internen Elektroden ein erstes elektrisches Potenzial (EP1) und an die zweiten internen Elektroden ein zweites elektrisches Potenzial (EP2) angelegt wird und wobei EP1 und EP2 gegensätzlicher Polarität sind.

4. Verfahren nach Anspruch 3, bei dem im Verfahrensschritt b') ein drittes elektrisches Potenzial (EP3) an zumindest eine, mit den ersten und zweiten internen Elektroden in Bezug stehende Gegenelektrode (CE) angelegt wird,
wobei im Verfahrensschritt b') die Potenziale EP2 und EP3 gegensätzlicher Polarität sind und der Betrag des Potenzials EP3 größer gewählt wird als der Betrag des Potenzials EP1.

5. Verfahren nach einem der Ansprüche 1-4, wobei in einem weiteren Verfahrensschritt d) nach dem Verfahrensschritt b) zumindest eine erste elektrische Außenkontaktierung (EM1) über der isolierenden Schicht der ersten Außenkanten (OE1) im elektrischen Kontakt mit den zweiten Außenkanten (OE2) auf zumindest der ersten Außenoberfläche (OF1) des Grundkörpers aufgetragen wird.

6. Verfahren nach einem der Ansprüche 2-4, wobei in einem weiteren Verfahrensschritt d') nach dem Verfahrensschritt b') zumindest eine zweite elektrische Außenkontaktierung (EM2) über der isolierenden Schicht der zweiten Außenkanten (OE2) im elektrischen Kontakt mit den ersten Außenkanten (OE1) auf zumindest der zweiten Außenoberfläche (OF2) des Grundkörpers aufgetragen wird.

7. Verfahren nach einem der Ansprüche 5 oder 6, wobei zunächst Verfahrensschritt b), gegebenenfalls Verfahrensschritt b'), und Verfahrensschritt c) erfolgt und erst anschließend der Verfahrensschritt d) sowie gegebenenfalls der Verfahrensschritt d') erfolgt.

8. Verfahren nach einem der Ansprüche 1-7, bei dem die Zusammensetzung (EC) folgende Komponenten beinhaltet: Partikel des Isoliermaterials (IM), einen polyionischen Dispergator (PD) und Lösungsmittel, wobei der polyionische Dispergator die Partikel unter Bildung des elektrophoretisch mobilen Isoliermaterials im Lösungsmittel dispergiert.

9. Verfahren nach Anspruch 8, bei dem die Partikel des Isoliermaterials (IM) Partikel zumindest eines elektrisch isolierenden Materials ausgewählt aus der Gruppe Glas, Keramik, temperaturbeständiger Kunststoff oder Kombinationen davon umfassen.

10. Verfahren nach Anspruch 8 oder 9, bei dem der polyionische Dispergator einen polyanionischen Dispergator umfasst, und im Verfahrensschritt b) und gegebenenfalls im Verfahrenschritt b') die zur Abscheidung des elektrophoretisch mobilen Isoliermaterials vorgesehenen internen Elektroden als Anode geschaltet sind.

11. Verfahren nach Anspruch 8 oder 9, bei dem der polyionische Dispergator einen polykationischen Dispergator umfasst, und im Verfahrensschritt b) und gegebenenfalls im Verfahrenschritt b') die zur Abscheidung des elektrophoretisch mobilen Isoliermaterials vorgesehenen internen Elektroden als Kathode geschaltet sind.

12. Verfahren nach einem der Ansprüche 1 bis 11, bei dem ein Grundkörper verwendet wird, welcher ein piezokeramisches Material umfasst.

13. Verfahren nach einem der Ansprüche 2-4, wobei im Verfahrensschritt a) eine Grundkörperanordnung (SBA) umfassend den keramischen Grundkörper (SB) bereitgestellt wird, wobei
- die Anordnung (SBA) zusätzlich eine dritte und eine vierte Außenoberfläche (OF3, OF4) aufweist,
- die ersten Außenkanten (OE1) sich zusätzlich auf der dritten Außenoberfläche (OF3) befinden und von der vierten Außenoberfläche (OF4) durch eine erste Isolationszone (IZ1) beabstandet vorliegen
- die zweiten Außenkanten (OE2) sich zusätzlich auf der vierten Außenoberfläche (OF4) befinden und von der dritten Außenoberfläche (OF3) durch eine zweite Isolationszone (IZ2) beabstandet vorliegen.

14. Verfahren nach Anspruch 13, wobei durch eine erste vorläufige Außenkontaktierung (PC1) auf der dritten Außenoberfläche (OF3) elektrischer Kontakt mit den ersten Außenkanten (OE1) und durch eine zweite vorläufige Außenkontaktierung (PC2) auf der vierten Außenoberfläche (OF4) elektrischer Kontakt mit den zweiten Außenkanten (OE2) hergestellt wird.

## Claims

1. Method for producing a ceramic component, comprising the following method steps:
a) providing a main body (SB) having internal electrodes, wherein the internal electrodes in the main body comprise at least one first internal electrode (IE1) having first outer edges (OE1) and at least one second internal electrode (IE2) having second outer edges (OE2) and the first and second outer edges are located on at least one first outer surface (OF1) of the main body,
b) contact-connecting the first outer surface (OF1) of the main body with a composition (EC) comprising an electrophoretically mobile insulating material (IM) and electrophoretically depositing the insulating material (IM) on the first outer edges (OE1) of the first internal electrodes on the first outer surface (OF1) of the main body and not on the second outer edges (OE2) of the second internal electrodes, wherein a first electrical potential (EP1) is applied to the first internal electrodes and a second electrical potential (EP2) is applied to the second internal electrodes, and wherein EP1 and EP2 are of opposing polarity, wherein a third electrical potential (EP3) is applied to at least one counterelectrode (CE) related to the first and second internal electrodes, wherein the potentials EP1 and EP3 are of opposing polarity and the magnitude of the potential EP3 is chosen to be greater than the magnitude of the potential EP2,
c) producing an insulating layer (IS) from the insulating material on the outer edges of the internal electrodes (IE1, IE2).

2. Method according to Claim 1, wherein the first and second outer edges are additionally located on at least one further second outer surface (OF2) of the main body, wherein, in a method step b') which takes place after b), the second outer surface (OF2) is contact-connected with a composition (EC), and wherein the insulating material on the second outer surface (OF2) is deposited only on the second outer edges (OE2) and not on the first outer edges (OE1).

3. Method according to Claim 2, wherein, in method step b'), a first electrical potential (EP1) is applied to the first internal electrodes and a second electrical potential (EP2) is applied to the second internal electrodes, and wherein EP1 and EP2 are of opposing polarity.

4. Method according to Claim 3, in which, in method step b'), a third electrical potential (EP3) is applied to at least one counterelectrode (CE) related to the first and second internal electrodes, wherein, in method step b'), the potentials EP2 and EP3 are of opposing polarity and the magnitude of the potential EP3 is chosen to be greater than the magnitude of the potential EP1.

5. Method according to one of Claims 1-4, wherein, in a further method step d) after method step b), at least one first electrical outer contact-making means (EM1) is applied to at least the first outer surface (OF1) of the main body in electrical contact with the second outer edges (OE2) over the insulating layer of the first outer edges (OE1).

6. Method according to one of Claims 2-4, wherein, in a further method step d') after method step b'), at least one second electrical outer contact-making means (EM2) is applied to at least the second outer surface (OF2) of the main body in electrical contact with the first outer edges (OE1) over the insulating layer of the second outer edges (OE2).

7. Method according to either of Claims 5 and 6, wherein firstly method step b), if appropriate method step b'), and method step c) are effected and only then are method step d) and if appropriate method step d') effected.

8. Method according to one of Claims 1-7, in which the composition (EC) contains the following components: particles of the insulating material (IM), a polyionic dispersant (PD) and solvent, wherein the polyionic dispersant disperses the particles in the solvent to form the electrophoretically mobile insulating material.

9. Method according to Claim 8, in which the particles of the insulating material (IM) comprise particles of at least one electrically insulating material selected from the group consisting of glass, ceramic, temperature-resistant plastic and combinations thereof.

10. Method according to Claim 8 or 9, in which the polyionic dispersant comprises a polyanionic dispersant, and in method step b) and if appropriate in method step b') the internal electrodes intended for the deposition of the electrophoretically mobile insulating material are connected as an anode.

11. Method according to Claim 8 or 9, in which the polyionic dispersant comprises a polycationic dispersant, and in method step b) and if appropriate in method step b') the internal electrodes intended for the deposition of the electrophoretically mobile insulating material are connected as a cathode.

12. Method according to one of Claims 1 to 11, in which use is made of a main body which comprises a piezoceramic material.

13. Method according to one of Claims 2-4, wherein, in method step a), a main body arrangement (SBA) comprising the ceramic main body (SB) is provided, wherein
- the arrangement (SBA) additionally has a third and a fourth outer surface (OF3, OF4),
- the first outer edges (OE1) are additionally located on the third outer surface (OF3) and are present spaced apart from the fourth outer surface (OF4) by a first insulating zone (IZ1),
- the second outer edges (OE2) are additionally located on the fourth outer surface (OF4) and are present spaced apart from the third outer surface (OF3) by a second insulating zone (IZ2).

14. Method according to Claim 13, wherein electrical contact is made with the first outer edges (OE1) by a first preliminary outer contact-making means (PC1) on the third outer surface (OF3) and electrical contact is made with the second outer edges (OE2) by a second preliminary outer contact-making means (PC2) on the fourth outer surface (OF4).

## Revendications

1. Procédé de fabrication d'un élément structural en céramique, comprenant les étapes de procédé suivantes :
a) mise à disposition d'un corps de base (SB) muni d'électrodes internes, les électrodes internes dans le corps de base comprenant au moins une première électrode interne (IE1) ayant des premiers bords extérieurs (OE1) et au moins une deuxième électrode interne (IE2) ayant des deuxièmes bords extérieurs (OE2) et les premiers et deuxièmes bords extérieurs se trouvant sur au moins une première surface extérieure (OF1) du corps de base,
b) mise en contact de la première surface extérieure (OF1) du corps de base avec une première composition (EC) comprenant un matériau isolant (IM) à mobilité électrophorétique et dépôt élecrophorétique du matériau isolant (IM) sur les premiers bords extérieurs (OE1) des premières électrodes internes sur la première surface extérieure (OF1) du corps de base et non sur les deuxièmes bords extérieurs (OE2) des deuxièmes électrodes internes, un premier potentiel électrique (EP1) étant appliqué aux premières électrodes internes et un deuxième potentiel électrique (EP2) aux deuxièmes électrodes internes, et EP1 et EP2 étant de polarités opposées,
un troisième potentiel électrique (EP3) étant appliqué à au moins une contre-électrode (CE) qui se trouve en rapport avec les premières et les deuxièmes électrodes internes, les potentiels EP1 et EP3 étant de polarités opposées et la valeur du potentiel EP3 étant choisie supérieure à la valeur du potentiel EP2,
c) génération d'une couche isolante (IS) à partir du matériau isolant sur les bords extérieurs des électrodes internes (IE1, IE2).

2. Procédé selon la revendication 1, selon lequel les premiers et deuxièmes bords extérieurs se trouvent en plus sur au moins une deuxième surface extérieure supplémentaire (OF2) du corps de base, dans une étape de procédé b') qui a lieu après b), la deuxième surface extérieure (OF2) étant mise en contact avec une composition (EC) et le matériau isolant sur la deuxième surface extérieure (OF2) n'étant déposé que sur les deuxièmes bords extérieurs (OE2) et non sur les premiers bords extérieurs (OE1).

3. Procédé selon la revendication 2, selon lequel à l'étape de procédé b'), un premier potentiel électrique (EP1) est appliqué aux premières électrodes internes et un deuxième potentiel électrique (EP2) aux deuxièmes électrodes internes, et EP1 et EP2 étant de polarités opposées.

4. Procédé selon la revendication 3, selon lequel, à l'étape de procédé b'), un troisième potentiel électrique (EP3) est appliqué à au moins une contre-électrode (CE) qui se trouve en rapport avec les premières et les deuxièmes électrodes internes, et à l'étape de procédé b') les potentiels EP2 et EP3 étant de polarités opposées et la valeur du potentiel EP3 étant choisie supérieure à la valeur du potentiel EP1.

5. Procédé selon l'une des revendications 1 à 4, selon lequel, dans une étape de procédé d) supplémentaire après l'étape de procédé b), au moins une première mise en contact extérieure électrique (EM1) par le biais de la couche isolante des premiers bords extérieurs (OE1) en contact électrique avec les deuxièmes bords extérieurs (OE2) est appliquée sur au moins la première surface extérieure (OF1) du corps de base.

6. Procédé selon l'une des revendications 2 à 4, selon lequel, dans une étape de procédé d') supplémentaire après l'étape de procédé b), au moins une deuxième mise en contact extérieure électrique (EM2) par le biais de la couche isolante des deuxièmes bords extérieurs (OE2) en contact électrique avec les premiers bords extérieurs (OE1) est appliquée sur au moins la deuxième surface extérieure (OF2) du corps de base.

7. Procédé selon l'une des revendications 5 ou 6, selon lequel d'abord l'étape de procédé b), le cas échéant l'étape de procédé b'), puis l'étape de procédé c) sont exécutées et ensuite seulement est exécutée l'étape de procédé d) ainsi que, le cas échéant, l'étape de procédé d').

8. Procédé selon l'une des revendications 1 à 7, selon lequel la composition (EC) contient les composants suivants : particules du matériau isolant (IM), un agent dispersant polyionique (PD) et un solvant, l'agent dispersant polyionique dispersant les particules dans le solvant en formant le matériau isolant à mobilité électrophorétique.

9. Procédé selon la revendication 8, selon lequel les particules du matériau isolant (IM) comprennent des particules d'au moins un matériau électriquement isolant choisi dans le groupe verre, céramique, matière plastique résistante à la température ou une combinaison de ceux-ci.

10. Procédé selon la revendication 8 ou 9, selon lequel l'agent dispersant polyionique comprend un agent dispersant polyanionique et, dans l'étape de procédé b) et éventuellement dans l'étape de procédé b'), les électrodes internes prévues pour le dépôt du matériau isolant à mobilité électrophorétique sont branchées en tant qu'anode.

11. Procédé selon la revendication 8 ou 9, selon lequel l'agent dispersant polyionique comprend un agent dispersant polycationique et, dans l'étape de procédé b) et éventuellement dans l'étape de procédé b'), les électrodes internes prévues pour le dépôt du matériau isolant à mobilité électrophorétique sont branchées en tant que cathode.

12. Procédé selon l'une des revendications 1 à 11, selon lequel est utilisé un corps de base qui comprend un matériau piézocéramique.

13. Procédé selon l'une des revendications 2 à 4, selon lequel, à l'étape de procédé a) est mis à disposition un arrangement de corps de base (SBA) comprenant le corps de base (SB) en céramique,
- l'arrangement (SBA) possédant en plus une troisième et une quatrième surface extérieure (OF3, OF4),
- les premiers bords extérieurs (OE1) se trouvant en plus sur la troisième surface extérieure (OF3) et étant présents espacés de la quatrième surface extérieure (OF4) par une première zone d'isolation (IZ1)
- les deuxièmes bords extérieurs (OE2) se trouvant en plus sur la quatrième surface extérieure (OF4) et étant présents espacés de la troisième surface extérieure (OF3) par une deuxième zone d'isolation (IZ2).

14. Procédé selon la revendication 13, selon lequel un contact électrique est établi par le biais d'une première mise en contact extérieure provisoire (PC1) sur la troisième surface extérieure (OF3) avec les premiers bords extérieurs (OE1) et un contact électrique est établi par le biais d'une deuxième mise en contact extérieure provisoire (PC2) sur la quatrième surface extérieure (OF4) avec les deuxièmes bords extérieurs (OE1).
